# EUROPÄISCHE PATENTSCHRIFT

(11) **EP 3 750 244 B1**
(45) Veröffentlichungstag und Bekanntmachung des Hinweises auf die Patenterteilung: **12.08.2026**
(21) Anmeldenummer: 19703694.0
(22) Anmeldetag: 05.02.2019
(51) Int. Cl.: H03K 17/96, B06B 1/06, G06F 3/01, H02N 2/04

(54) **VORRICHTUNG UND VERFAHREN ZUR ERZEUGUNG EINER AKTIVEN HAPTISCHEN RÜCKMELDUNG**
DEVICE AND METHOD FOR PRODUCING ACTIVE HAPTIC FEEDBACK
PROCÉDÉ ET DISPOSITIF POUR GÉNÉRER UN RETOUR HAPTIQUE ACTIF

(30) Priorität: 06.02.2018 DE 102018102630
(43) Veröffentlichungstag der Anmeldung: 16.12.2020
(73) Patentinhaber: TDK Electronics AG, 81671 München (DE)
(72) Erfinder: NEUWIRTH, Daniel, 8523 Frauental (AT); PUCHLEITNER, Roman, 8083 St. Stefan (AT); RAJAPURKAR, Aditya, 8042 Graz (AT); PENTSCHER-STANI, Andreas, 8430 Leibnitz (AT)
(74) Vertreter: Epping - Hermann - Fischer
(86) Internationale Anmeldenummer: PCT/EP2019/052786
(87) Internationale Veröffentlichungsnummer: WO 2019/154810

(56) Entgegenhaltungen:
- EP-A1- 2 461 234
- EP-A2- 3 232 299
- WO-A1-2014/164018
- CA-A1- 2 996 919
- FR-A1- 3 000 301
- US-A1- 2010 096 949
- US-B2- 9 590 624

## Beschreibung

Die vorliegende Erfindung betrifft einen Vorrichtung zur Erzeugung einer aktiven haptischen Rückmeldung sowie ein Verfahren zur Erzeugung einer aktiven haptischen Rückmeldung.

Mechanische Tasten und Schalter zur Bedienung von Geräten werden in einem zunehmenden Maß durch rein elektronische Varianten, beispielsweise Touch-Bildschirme, ersetzt. Bei der Verwendung eines herkömmlichen mechanischen Schalters signalisiert das Überwinden eines Schaltpunktes durch einen Kraftsprung, dass die Taste erfolgreich gedrückt wurde.

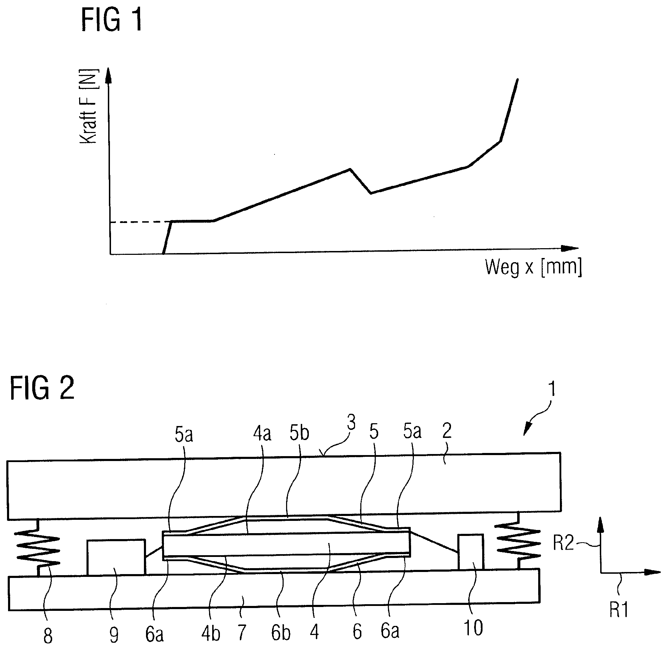

Figur 1 zeigt ein Kraft-Weg-Diagramm einer mechanischen Taste. Dabei ist auf der Abszissenachse der Weg aufgetragen, um den eine mechanische Taste gedrückt wird. Auf der Ordinatenachse ist die auf die Taste ausgeübte Kraft aufgetragen.

Zunächst wird eine Taste fast ohne Aufwand einer Kraft gedrückt. Die mechanische Taste kann durch eine Feder vorgespannt sein. Erst wenn die Federspannung zu überwinden ist, steigt die aufzuwendende Kraft. Dabei kommt es zunächst zu einem Leerhub, bei dem die Kraft konstant bleibt, danach steigt die Kraft linear an. Wird der Schaltpunkt SP erreicht, nimmt die Kraft in Form eines Kraftsprungs ab. Der Schaltpunkt SP ist in Figur 1 durch das Bezugszeichen SP gekennzeichnet.

Der Kraftsprung wird von dem Nutzer wahrgenommen und signalisiert dem Nutzer eine erfolgreiche Betätigung der Taste. Nach Überwindung des Schaltpunktes SP und nach dem Kraftsprung steigt die aufzubringende Kraft wiederum **an.** Kurz bevor ein mechanischer Endanschlag der Taste erreicht ist, steigt die aufzubringende Kraft immer stärker **an.**

Entscheidend für das Betätigungserlebnis ist der Kraftsprung, der bei Überwindung des Schaltpunkts auftritt. Der Nutzer spürt die Abnahme des mechanischen Widerstands der Taste und erkennt daran, dass die Taste erfolgreich getätigt wurde. Selbst in einer sehr lauten Umgebung, in der eine akustische Rückmeldung nicht wahrgenommen werden könnte, wird durch diesen haptischen Eindruck dem Nutzer zuverlässig bestätigt, dass die Taste gedrückt wurde.

Bei rein elektronischen Mensch-Maschine-Schnittstellen fehlt es an einer haptischen Rückmeldung in Form des Kraftsprungs. Um zu erkennen, dass eine solche Schnittstelle korrekt bedient wurde, ist der Benutzer daher häufig gezwungen, aktiv auf ein Display zu sehen. Dadurch kann der Benutzer abgelenkt werden. Beispielsweise werden Touch-Bildschirme zunehmend auch in Fahrzeugen eingesetzt. Hierbei könnte es eine Beeinträchtigung der Sicherheit darstellen, wenn der Benutzer gezwungen wird, auf den Bildschirm zu sehen. Um diesen Nachteil zu umgehen, ist es üblich, Touch-Bildschirme mit einem haptischen Feedback zu versehen.

Beispiele für Vorrichtungen zur Erzeugung einer haptischen Rückmeldung sind aus EP 2 461 233 B1 und WO 2016/075131 A1 bekannt. Bei diesen Vorrichtungen sind die erreichbaren Auslenkungen jedoch sehr begrenzt. Aufgrund der nur kleinen erreichbaren Auslenkungen sind diese nur in einem engen Frequenzband etwa zwischen 150 Hz und 250 Hz gut spürbar, da hier der menschliche Tastsinn am empfindlichsten ist. CA 2 996 919 A1 zeigt eine weitere Vorrichtung zur Erzeugung einer haptischen Rückmeldung, die einen piezoelektrischen Aktuator mit kegelstumpfförmigen Blechen aufweist.

Aufgabe der vorliegenden Erfindung ist es nunmehr, eine verbesserte Vorrichtung und ein verbessertes Verfahren zur Erzeugung einer haptischen Rückmeldung anzugeben, wobei beispielsweise die Nachteile der oben genannten Vorrichtungen überwunden werden. Diese Aufgabe wird durch die Gegenstände der unabhängigen Ansprüche gelöst.

Es wird eine Vorrichtung vorgeschlagen, die wenigstens einen piezoelektrischen Aktuator, ein erstes Verstärkungselement, ein zweites Verstärkungselement und eine Treiberschaltung aufweist. Der piezoelektrische Aktuator weist eine Vielzahl von piezoelektrischen Schichten und dazwischen angeordneten Innenelektroden auf. Der piezoelektrische Aktuator ist zwischen den Verstärkungselementen angeordnet, wobei der piezoelektrische Aktuator dazu ausgebildet und angeordnet ist, seine Ausdehnung bei Anlegen einer elektrischen Spannung in eine erste Richtung zu verändern und wobei die Verstärkungselemente dazu ausgebildet und angeordnet sind, sich in Folge der Änderung der Ausdehnung des piezoelektrischen Aktuators derart zu verformen, das ein Teilbereich des jeweiligen Verstärkungselements relativ zu dem piezoelektrischen Aktuator in eine zweite Richtung, die senkrecht zu der ersten Richtung ist, bewegt wird. Die Treiberschaltung ist dazu ausgestaltet, eine elektrische Spannung an den piezoelektrischen Aktuator anzulegen, sodass die Verstärkungselemente derart verformt werden, dass gegenüber einem auf die Vorrichtung drückenden Objekt eine haptische Rückmeldung erzeugt wird, die einen Kraftsprung nachbildet.

Der piezoelektrische Aktuator bietet gegenüber anderen Mitteln zur Erzeugung einer haptischen Rückmeldung, beispielsweise Unwuchtmotoren oder Linearresonatoren, den Vorteil, einer deutlich kürzeren Ansprechzeit. Eine kurze Ansprechzeit kann dafür sorgen, dass zwischen einem Betätigen einer Taste und dem Beginn der haptischen Rückmeldung nicht zu viel Zeit vergeht und es somit nicht zu einer Irritation des Benutzers kommt. Nur durch eine kurze Ansprechzeit kann das haptische Verhalten einer mechanischen Taste möglichst exakt nachgebildet werden und der Nutzer kann das von ihm intuitiv erwartete Gefühl erfahren. Dadurch kann das Benutzungserlebnis für den Benutzer generell verbessert werden.

Durch die Verwendung der beiden Verstärkungselemente kann es ermöglicht werden, die Amplitude der Bewegung, die für die Erzeugung der haptischen Rückmeldung entscheidend ist, erheblich zu vergrößern. Die Verstärkungselemente können derart ausgestaltet sein, dass eine Bewegung des piezoelektrischen Aktuators in eine erste Richtung übersetzt wird in eine Bewegung in eine zweite Richtung, deren Amplitude um einen Faktor von zumindest **5,** vorzugsweise um einen Faktor von zumindest 10, größer ist als die Bewegung in die erste Richtung. Dadurch können die Verstärkungselemente dafür sorgen, dass die haptische Rückmeldung deutlich stärker ist als dies der Fall wäre, wenn die Längenänderung des piezoelektrischen Aktuators selbst zur Erzeugung der haptischen Rückmeldung verwendet würde. Dadurch kann sichergestellt werden, dass die erreichten Auslenkungen selbst in einer hektischen Situation vom Benutzer zuverlässig wahrgenommen werden können. Es kann somit sichergestellt werden, dass ein haptisches Feedback bereitgestellt wird, das weit über der vom Benutzer wahrnehmbaren Detektionsschwelle liegt.

Darüber hinaus kann die haptische Rückmeldung aufgrund der Verwendung der Verstärkungselemente auch stark genug sein, um bei schweren Mensch-Maschine-Schnittstellen, beispielsweise großen Bildschirmen, eingesetzt zu werden. Ohne die Verwendung der Verstärkungselemente könnten solche schweren Mensch-Maschine-Schnittstellen nicht ausreichend stark bewegt werden.

Bei der Änderung der Ausdehnung des piezoelektrischen Aktuators in die erste Richtung kann es sich insbesondere um eine Längenänderung in eine Richtung senkrecht zu einer Stapelrichtung handeln, wobei die piezoelektrischen Schichten und die Innenelektroden in der Stapelrichtung übereinander angeordnet sind. Die Änderung der Ausdehnung des piezoelektrischen Aktuators in die erste Richtung kann somit eine Querkontraktion des Aktuators sein. Zu der Änderung der Ausdehnung des piezoelektrischen Aktuators in die erste Richtung kann es in Folge des piezoelektrischen Effekts kommen, der in den piezoelektrischen Schichten durch die zwischen den ersten und zweiten Innenelektroden angelegte Spannung entsteht.

Die zweite Richtung, in die sich die Teilbereiche der Verstärkungselemente bewegen, kann die Stapelrichtung des piezoelektrischen Aktuators sein.

Die haptische Rückmeldung ist derart ausgestaltet, dass ein Kraftsprung nachgebildet wird. Insbesondere kann für einen auf die Mensch-Maschine-Schnittstelle drückenden Nutzer der Eindruck eines Kraftsprungs erzeugt werden. Dabei kann der Nutzer mit seinem Finger oder einem Objekt, wie einem Stift, auf die Schnittstelle drücken. Der Eindruck eines Kraftsprungs kann durch eine sehr kurze Vibration erzeugt werden, die dem Nutzer das Gefühl vermittelt, dass ein mechanischer Widerstand kurzzeitig verringert wird, wie dies beim Überwinden des Schaltpunktes SP einer mechanischen Taste üblich ist. Unter einer Vibration kann dabei eine kurzfristige Vibration verstanden werden, die vom Nutzer als singuläres Ereignis wahrgenommen wird.

Die Treiberschaltung kann dazu ausgelegt sein, eine elektrische Spannung an dem piezoelektrischen Aktuator anzulegen, die die Form eines einzelnen Sinusimpulses, eines einzelnen Rechteckimpulses, eines einzelnen Sägezahnimpulses, eines einzelnen Halb-Sinusimpulses, eines einzelnen Halb-Rechteckimpulses oder eines einzelnen Halb-Sägezahnimpulses hat. Alternativ kann die Treiberschaltung dazu ausgelegt sein, eine elektrische Spannung an dem piezoelektrischen Aktuator anzulegen, die die Form mehrerer Sinusimpulse, mehrerer Rechteckimpulse, mehrerer Sägezahnimpulse, mehrerer Halb-Sinusimpulse, mehrerer Halb-Rechteckimpulse oder mehrerer Halb-Sägezahnimpulse hat. Die mehreren Pulse können dabei vom Benutzer als singuläres Ereignis wahrgenommen werden. Bei den mehreren Pulsen kann es sich beispielsweise jeweils um zwei Pulse handeln. Durch die Benutzung mehrerer Pulse kann die Rückmeldung im Vergleich zu einem Puls verstärkt werden.

Bei all diesen Formen kann die angelegte Spannung in einer kurzen Zeit stark verändert werden. Die starke Veränderung kann bei dem Sägezahn- und Rechteckimpulsen sprungartig sein.

Bei den sinus- beziehungsweise halb-sinusförmigen Impulsen wird die starke Veränderung durch eine hinreichend steile Flanke des Impulses bewirkt. Durch eine starke Veränderung der angelegten Spannung kann der Aktuator in Vibration versetzt werden, die zu einer Vibration der Teilbereiche der Verstärkungselemente führt. Wie bereits erläutert wird eine kurze Vibration von einem Nutzer als Kraftsprung wahrgenommen und vermittelt auf diese Weise den Eindruck des Überwindens eines Schaltpunktes.

Darüber hinaus könnte die angelegte Spannung auch eine beliebige andere Form haben, sofern innerhalb einer hinreichend kurzen Zeit die Spannung um einen ausreichend großen Betrag geändert wird.

Gemäß einem Vergleichsbeispiel ist die Treiberschaltung dazu ausgelegt, die elektrische Spannung in Form eines Spannungspulses oder mehrerer Spannungspulse an den piezoelektrischen Aktuator anzulegen, wenn auf die Vorrichtung eine Kraft ausgeübt wird und die auf die Vorrichtung ausgeübte Kraft eine Kraftschwelle überschreitet. Der Spannungspuls kann insbesondere rechteckförmig oder sinusförmig sein. Durch den Spannungspuls wird eine Vibration des piezoelektrischen Aktuators ausgelöst, die von dem Nutzer als Kraftsprung wahrgenommen wird.

Gemäß einem Vergleichsbeispiel kann die Treiberschaltung dazu ausgelegt sein, eine an den piezoelektrischen Aktuator angelegte elektrische Spannung sprungartig zu erhöhen, wenn auf die Vorrichtung eine Kraft ausgeübt wird und die auf die Vorrichtung ausgeübte Kraft eine Kraftschwelle überschreitet. Durch die Vordefinition der Kraftschwelle kann festgelegt werden, bei welcher aufgebrachten Kraft der nachgebildete Schaltpunkt liegt.

Die Treiberschaltung kann in einem weiteren Vergleichsbeispiel ferner dazu ausgelegt sein, die an den piezoelektrischen Aktuator angelegte elektrische Spannung konstant zu halten, bis die auf die Vorrichtung ausgeübte Kraft die Kraftschwelle unterschreitet. Beim Unterschreiten der Kraftschwelle kann die Spannung sprungartig abgebaut werden. Dadurch kann es ermöglicht werden, dass der piezoelektrische Aktuator sowohl beim Überschreiten als auch beim Unterschreiten der Kraftschwelle jeweils vibriert und dementsprechend zweimal eine haptische Rückmeldung erzeugt wird. Dem Nutzer wird das Gefühl eines Kraftsprungs dabei sowohl beim Betätigen als auch beim Loslassen der Taste vermittelt.

Die Vorrichtung kann dazu ausgestaltet sein, eine auf die Vorrichtung ausgeübte Kraft zu erkennen. Dazu kann beispielsweise ein separater Drucksensor verwendet werden, der an der Mensch-Maschine-Schnittstelle angeordnet ist, und eine auf die Mensch-Maschine-Schnittstelle ausgeübten Druck misst.

Wenn die Vorrichtung erkennt, dass die auf sie ausgeübte Kraft die vordefinierte Kraftschwelle übersteigt, kann die haptische Rückmeldung erzeugt werden. Dazu kann dann eine elektrische Spannung an den piezoelektrischen Aktuator angelegt werden.

In einem Ausführungsbeispiel ist die Vorrichtung dazu ausgestaltet, eine zwischen den Innenelektroden des piezoelektrischen Aktuators erzeugte Spannung, die in Folge einer auf die Vorrichtung ausgeübten Kraft entsteht, zu erkennen. Ferner kann die Vorrichtung dazu ausgestaltet sein, anhand der Höhe der zwischen den Innenelektroden erzeugten Spannung die auf die Vorrichtung ausgeübte Kraft zu erkennen. In diesem Fall kann auf den Drucksensor verzichtet werden. Es ergibt sich dadurch ein kompakter Aufbau, der wenige Komponenten aufweist.

Die Innenelektroden können dementsprechend eine Doppelfunktion in der Vorrichtung wahrnehmen. Sie können einerseits dazu dienen, eine auf die Mensch-Maschine-Schnittstelle ausgeübte Kraft zu erkennen, da in diesem Fall zwischen ihnen eine Spannung erzeugt wird, und andererseits die Längenänderung des Aktuators auslösen, mittels der die aktive haptische Rückmeldung erzeugt wird, wenn zwischen ihnen eine elektrische Spannung angelegt wird.

Die Vorrichtung kann dazu ausgestaltet sein, die aktive haptische Rückmeldung dadurch zu erzeugen, dass zwischen den Innenelektroden des piezoelektrischen Aktuators eine elektrische Spannung angelegt wird, die zu einer Längenänderung des Aktuators führt. Die Vorrichtung kann dazu ausgestaltet sein, die haptische Rückmeldung zu erzeugen, die den Kraftsprung nachbildet, indem die an den piezoelektrischen Aktuator angelegte Spannung sprungartig verändert wird, wodurch der piezoelektrische Aktuator in eine Vibration versetzt wird.

Eine Frequenz der Vibration des piezoelektrischen Aktuators und damit einer Vibration der Teilbereiche der Verstärkungselemente kann in einem großen Bereich von 10 Hz bis 500 Hz liegen. Da auf Grund der Verwendung der Verstärkungselemente eine starke haptische Rückmeldung erzeugt werden kann, die weiter über der Detektionsschwelle eines Nutzers liegt, ist die Rückmeldung nicht auf den Frequenzbereich von 150 Hz bis 200 Hz beschränkt, in dem die Pacini-Korpuskeln und damit der menschliche Tastsinn am empfindlichsten ist. Vielmehr kann auch eine haptische Rückmeldung mit geringeren Frequenzen, in einem Bereich von 10 Hz bis 100 Hz, oder mit größeren Frequenzen, in einem Bereich von 250 Hz bis 500 Hz, erzeugt werden, die von einem Nutzer zuverlässig wahrgenommen werden kann. Durch eine große Amplitude der Bewegung der Teilbereiche der Verstärkungselemente in die zweite Richtung kann sichergestellt werden, dass der Nutzer die haptische Rückmeldung selbst dann zuverlässig wahrnimmt, wenn ihre Frequenz außerhalb des Bereichs 150 Hz bis 200 Hz liegen sollte.

Das erste Verstärkungselement kann ein kegelstumpfförmiges Blech aufweisen. Das zweite Verstärkungselement kann ein kegelstumpfförmiges Blech aufweisen.

Die Verstärkungselemente können jeweils dazu ausgestaltet sein, eine Längenänderung des Aktuators in die erste Richtung in eine Längenänderung in die zweite Richtung zu transformieren. Die Verstärkungselemente können jeweils dazu dienen, eine Längenänderung des Aktuators, zu der es infolge einer Querkontraktion des Aktuators kommt, zu verstärken. Zu diesem Zweck können die Verstärkungselemente jeweils derartig geformt sein, dass es beim Zusammenziehen oder Auseinanderziehen der Randbereiche der Verstärkungselemente zu einer erheblichen Anhebung oder Absenkung eines mittleren Bereiches der Verstärkungselemente kommt. Die Verstärkungselemente können jeweils mit dazu beitragen, die Querkontraktion des Grundkörpers in eine erhebliche Längenänderung in Stapelrichtung des Aktuators umzuwandeln.

Das kegelstumpfförmige Blech kann einen Randbereich aufweisen, der auf der Oberseite beziehungsweise der Unterseite des Aktuators befestigt ist. Der Randbereich kann beispielsweise mittels Kleben, Löten oder Schweißen an dem Aktuator befestigt sein. Das Blech kann ferner einen mittleren Bereich aufweisen, der in Stapelrichtung von der Oberseite beziehungsweise der Unterseite des Aktuators absteht. Der Abstand des mittleren Bereichs des Blechs von der Oberseite beziehungsweise der Unterseite kann sich erheblich verändern, wenn der Aktuator infolge einer zwischen den Innenelektroden angelegten Spannung eine Querkontraktion erfährt.

Das Blech kann Titan aufweisen oder aus Titan bestehen. Titan weist insbesondere für die hier vorliegende Anwendung zur Erzeugung eines aktiven haptischen Feedbacks wesentliche Vorteile auf. Bei der Betätigung der Vorrichtung von einem Menschen kann Feuchtigkeit, beispielsweise in Form von Fingerschweiß, auf das Blech gelangen. Diese kann zu Korrosion führen. Titan ist jedoch ein besonders korrosionsbeständiges Material, sodass es die Vorrichtung gut vor Langzeitschäden durch Korrosion schützen kann.

Ferner weist Titan eine hohe mechanische Belastbarkeit auf, sodass es die Lebensdauer des Bauelementes verlängern kann.

Außerdem weist Titan einen thermischen Ausdehnungskoeffizienten auf, der sehr nahe an dem thermischen Ausdehnungskoeffizienten des Aktuators liegt. Dadurch wird die Verbindungsstelle des Blechs mit dem Aktuator bei einer Veränderung der Temperatur nicht wesentlich mechanisch belastet.

Das mechanische Verstärkungselement kann ein Metallbügel sein. Ein derartiges Verstärkungselement kann in Kombination mit einem quaderförmigen piezoelektrischen Aktuator verwendet werden, der eine Länge aufweist, die größer ist als seine Breite. Ein derartiger länglicher Aktuator und das zugehörige bügelförmige Verstärkungselement ermöglichen gegenüber einem Aktuator mit einer quadratischen Grundfläche und einem kegelstumpfförmigen Verstärkungselement eine verbesserte Miniaturisierung und zusätzlich können höhere Kräfte bei gleicher Eingangsspannung erzeugt werden.

Das mechanische Verstärkungselement kann frei von Einkerbungen sein und eine konstante Wandstärke aufweisen. Alternativ kann das mechanische Verstärkungselement zumindest eine Einkerbung aufweisen, die einen mechanischen Widerstand gegen eine Verformung des mechanischen Verstärkungselements reduziert. Die Einkerbungen können dafür sorgen, dass das Verstärkungselement mit einer kleinen Kraft verformt werden kann. Allerdings kann es vorteilhaft sein, auf Einkerbungen zu verzichten, wenn Verstärkungselemente mit einer geringen Dicke konstruiert werden, da diese ansonsten zu instabil sein könnten.

Der piezoelektrische Aktuator kann eine quadratische Grundfläche aufweisen. Alternativ kann der piezoelektrische Aktuator eine Grundfläche aufweist, deren Länge größer ist als deren Breite. Die Grundfläche kann dabei eine Fläche sein, deren Flächennormale in eine Stapelrichtung weist, in der Elektroden und piezoelektrisches Material gestapelt ist. Die Länge kann die Ausdehnung der längsten Seite der Grundfläche bezeichnen. Die Breite kann die Ausdehnung der kürzesten Seite der Grundfläche bezeichnen.

Die Vorrichtung kann eine Grundplatte und eine Mensch-Maschine-Schnittstelle, die dazu ausgestaltet ist, von dem Objekt betätigt zu werden, aufweisen, wobei der piezoelektrische Aktuator zwischen der Grundplatte und der Mensch-Maschine-Schnittstelle angeordnet ist. Die haptische Rückmeldung kann insbesondere dadurch erzeugt werden, dass die Bewegung der Teilbereiche der Verstärkungselemente zueinander transformiert wird in eine Bewegung der Mensch-Maschine-Schnittstelle relativ zu der Grundplatte.

Gemäß einem weiteren Aspekt betrifft die vorliegende Erfindung ein Verfahren zur Erzeugung einer aktiven haptischen Rückmeldung mit der oben beschriebenen Vorrichtung. Dabei wird von der Treiberschaltung eine an den piezoelektrischen Aktuator angelegte elektrische Spannung verändert, wenn eine auf die Vorrichtung wirkende Kraft, eine Kraftschwelle überschreitet.

Im Folgenden wird die vorliegende Erfindung anhand der Figuren weiter erläutert.
Figur 1 zeigt ein Kraft-Weg-Diagramm einer mechanischen Taste.
Figur 2 zeigt eine Vorrichtung 1 zur Erzeugung einer aktiven haptischen Rückmeldung.
Figur 3 zeigt das Verhalten des piezoelektrischen Aktuators, das sich bei Anlegen eines einzelnen halbsinusförmigen Impulses ergibt.
Figur 4 zeigt einen Sägezahnimpuls, der als elektrische Spannung an einen Aktuator angelegt werden kann.
Figur 5 zeigt ein Kraft-Weg-Diagramm, das zeigt, wie der Nutzer die Betätigung einer Mensch-Maschine-Schnittstelle wahrnimmt.
Figur 6 zeigt einen piezoelektrischen Aktuator und zugehörige Verstärkungselemente in perspektivischer Ansicht.
Figur 7 zeigt eine Seitenansicht des piezoelektrischen Aktuators und der zugehörigen Verstärkungselemente.
Figur 8 zeigt eine Draufsicht auf eine Oberseite des Aktuators.

Figur 2 zeigt eine Vorrichtung 1 zur Erzeugung einer aktiven haptischen Rückmeldung. Die aktive haptische Rückmeldung ist dabei dazu ausgestaltet, bei einem Nutzer, der auf die Vorrichtung 1 einen Druck ausübt, das Gefühl des Drückens einer mechanischen Taste zu erzeugen. Zu diesem Zweck ist die Vorrichtung 1 derart ausgestaltet, dass die erzeugte haptische Rückmeldung einen Kraftsprung nachbildet.

Die Vorrichtung 1 weist eine Mensch-Maschine-Schnittstelle 2 auf. Dabei handelt es sich um ein Betätigungselement, das von einem Nutzer der Vorrichtung 1 betätigt werden kann. Beispielsweise kann es sich bei der Mensch-Maschine-Schnittstelle 2 um einen Touch-Bildschirm, wie er beispielsweise bei Mobiltelefonen oder anderen Endgeräten üblich ist, handeln. Der Nutzer kann die Mensch-Maschine-Schnittstelle 2 betätigen, indem er mit einem Finger oder einem Objekt, beispielsweise einem Stift, auf eine Bedienoberfläche 3 der Mensch-Maschine-Schnittstelle 2 drückt.

Die Vorrichtung 1 weist ferner einen piezoelektrischen Aktuator 4 auf. Bei dem piezoelektrischen Aktuator 4 handelt es sich um ein Vielschichtbauelement, das abwechselnd angeordnete Schichten von piezoelektrischem Material und Innenelektroden aufweist. Der piezoelektrische Aktuator 4 ist dazu ausgestaltet, sich in Folge einer angelegen elektrischen Spannung zu verformen. Insbesondere ist der piezoelektrische Aktuator 4 dazu ausgestaltet, seine Länge in eine erste Richtung R1 zu ändern, wenn eine an den piezoelektrischen Aktuator 4 angelegte Spannung geändert wird.

Die Vorrichtung 1 weist ferner ein erstes Verstärkungselement 5 und ein zweites Verstärkungselement 6 auf. Das erste Verstärkungselement 5 ist an einer Oberseite 4a des piezoelektrischen Aktuators 4 angeordnet, die der Mensch-Maschine-Schnittstelle 2 zugewandt ist. Das zweite Verstärkungselement 6 ist an einer Unterseite 4b des piezoelektrischen Aktuators 4 angeordnet, die von der Mensch-Maschine-Schnittstelle 2 abgewandt ist.

Bei jedem der Verstärkungselemente 5, 6 handelt es sich um ein kegelstumpfförmiges Blech, wobei Randbereiche 5a, 6a des Blechs auf der Oberseite 4a beziehungsweise der Unterseite 4b des piezoelektrischen Aktuators 4 befestigt sind und ein mittlerer Bereich 5b, 6b des jeweiligen Bleches von dem piezoelektrischen Aktuator 4 beabstandet ist. Die Verstärkungselemente 5, 6 sind dazu ausgestaltet, eine Längenänderung des piezoelektrischen Aktuators 4 in eine erste Richtung R1 umzuwandeln in eine Bewegung in eine zweite Richtung R2, die senkrecht zu der ersten Richtung ist. Dabei sind die Verstärkungselemente ferner derart ausgestaltet, dass eine Amplitude der Bewegung in die zweite Richtung größer ist als eine Amplitude der Bewegung in die erste Richtung.

Die Vorrichtung weist ferner eine Grundplatte 7 auf. Der mittlere Bereich 5b des ersten Verstärkungselements 5 ist an der Mensch-Maschine-Schnittstelle 2 befestigt. Der mittlere Bereich 6b des zweiten Verstärkungselementes 6 ist an der Grundplatte 7 befestigt. Werden nun die mittleren Bereiche 5b, 6b der Verstärkungselemente 5, 6 relativ zueinander in die zweite Richtung R2 bewegt, so wird diese Bewegung übertragen auf eine Bewegung der Mensch-Maschine-Schnittstelle 2 relativ zu der Grundplatte 7. Die Grundplatte 7 ist um ein Vielfaches schwerer als die Mensch-Maschine-Schnittstelle 2, sodass die Grundplatte 7 im Wesentlichen unbewegt bleibt. Wird die Mensch-Maschine-Schnittstelle 2 relativ zu der Grundplatte 7 bewegt, so entsteht für einen auf die Mensch-Maschine-Schnittstelle 2 drückenden Nutzer eine haptische Rückmeldung.

Die Amplitude der Bewegung der Mensch-Maschine-Schnittstelle 2 wird dabei durch die Amplitude Bewegung der beiden Verstärkungselemente 5, 6 in die zweite Richtung R2 festgelegt. Diese Bewegung weist eine größere Amplitude auf als die Längenänderung des piezoelektrischen Aktuators 4 in die erste Richtung R1. Daher ist die erzeugte haptische Rückmeldung deutlich stärker als dies der Fall wäre, wenn die Bewegung des piezoelektrischen Aktuators 4 selbst zur Erzeugung der haptischen Rückmeldung verwendet würde. Auf Grund der großen Amplitude der hier für die haptische Rückmeldung verantwortlichen Bewegung kann die Rückmeldung von einem Benutzer auch in hektischen Situationen zuverlässig wahrgenommen werden. Darüber hinaus könnte auch eine schwere Mensch-Maschine-Schnittstelle 2, beispielsweise ein großer Bildschirm, verwendet werden. Auf Grund der starken haptischen Rückmeldung ermöglicht es diese Ausgestaltung der Vorrichtung 1 ferner, ein sehr breites Frequenzspektrum für die Erzeugung der haptischen Rückmeldung einzusetzen.

Ferner weist die Vorrichtung zumindest zwei Federn 8 auf. Die beiden Federn 8 sind zwischen der Mensch-Maschine-Schnittstelle 2 und der Grundplatte 7 angeordnet und werden dabei zwischen der Mensch-Maschine-Schnittstelle 2 und der Grundplatte 7 zusammengedrückt und somit gespannt. Durch die Federn 8 wird die Mensch-Maschine-Schnittstelle 2 in einer Lage parallel zu der Grundplatte 7 gefedert aufgehängt. Die Federn 8 verhindern dabei eine Kippbewegung der Mensch-Maschine-Schnittstelle 2 relativ zu der Grundplatte 8. Gleichzeitig bieten die Federn 8 eine hinreichende Bewegungsfreiheit, sodass die Mensch-Maschine-Schnittstelle 2 bei Bewegungen des piezoelektrischen Aktuators 4 relativ zu der Grundplatte 7 in die zweite Richtung R2 bewegt werden kann. Die Amplitude einer solchen Bewegung ist üblicherweise kleiner als 1mm, vorzugsweise kleiner als 500 µm.

Die Vorrichtung 1 weist ferner eine Messeinheit 9 auf. Die Messeinheit ist in Figur 2 schematisch angedeutet. Die Messeinheit 9 ist mit zumindest zwei Innenelektroden des piezoelektrischen Aktuators 4 verbunden und kann erkennen, wenn eine elektrische Spannung zwischen den Innenelektroden erzeugt wird. Drückt ein Nutzer auf die Mensch-Maschine-Schnittstelle 2, so wird diese Kraft über die Mensch-Maschine-Schnittstelle 2 und das erste Verstärkungselement 5 auf den piezoelektrischen Aktuator 4 ausgeübt. Dadurch entsteht in dem piezoelektrischen Aktuator 4 eine elektrische Spannung, die von der Messeinheit 9 registriert wird. Die Messeinheit 9 kann nunmehr aus dieser registrierten elektrischen Spannung auf die auf die Vorrichtung 1 ausgeübte Kraft rückschließen.

In einem nicht gezeigten alternativen Ausführungsbeispiel kann die Vorrichtung 1 einen separaten Kraftsensor aufweisen, der eine auf die Mensch-Maschine-Schnittstelle 2 ausgeübte Kraft erkennt. In diesem Fall wird nicht die in dem Aktuator 4 erzeugte Spannung zur Messung der Kraft verwendet.

Ferner weist die Vorrichtung 1 eine Treiberschaltung 10 auf, die dazu ausgestaltet ist, eine elektrische Spannung an den Aktuator 4 anzulegen, um die aktive haptische Rückmeldung zu erzeugen. Im Folgenden werden verschiedene an den Aktuator 4 anlegbare Spannungen betrachtet, die es jeweils ermöglichen eine aktive haptische Rückmeldung zu erzeugen, die den Eindruck eines Kraftsprungs erzeugt.

Wird die elektrische Spannung an den Aktuator 4 angelegt, so verändert sich die Länge des Aktuators 4 in die erste Richtung R1 und durch die Verstärkungselemente 5, 6 wird diese Längenänderung in eine Bewegung in die zweite Richtung R2 mit vergrößerter Amplitude umgewandelt. Dabei werden die mittleren Bereiche 5b, 6b der beiden Verstärkungselemente 5, 6 entweder voneinander wegbewegt oder aufeinander zu bewegt. Durch das Anlegen der elektrischen Spannung an den piezoelektrischen Aktuator 4, wird eine kurze Vibration des Aktuators erzeugt, die von einem Nutzer, der auf die Mensch-Maschine-Schnittstelle 2 drückt, als haptische Rückmeldung wahrgenommen wird.

Es kommt immer dann zu der Erzeugung einer haptischen Rückmeldung, wenn die an den piezoelektrischen Aktuator 4 angelegte Spannung in kurzer Zeit, beispielsweise innerhalb eines Zeitraums von weniger als 10 ms, deutlich verändert wird. Durch eine Veränderung der an den piezoelektrischen Aktuator 4 angelegten Spannung, wird dieser in eine Vibration versetzt, da sich seine Länge ändert. Dieses geschieht sowohl bei einer schnellen Erhöhung der angelegten Spannung als auch bei einem schnellen Abfall der angelegten Spannung.

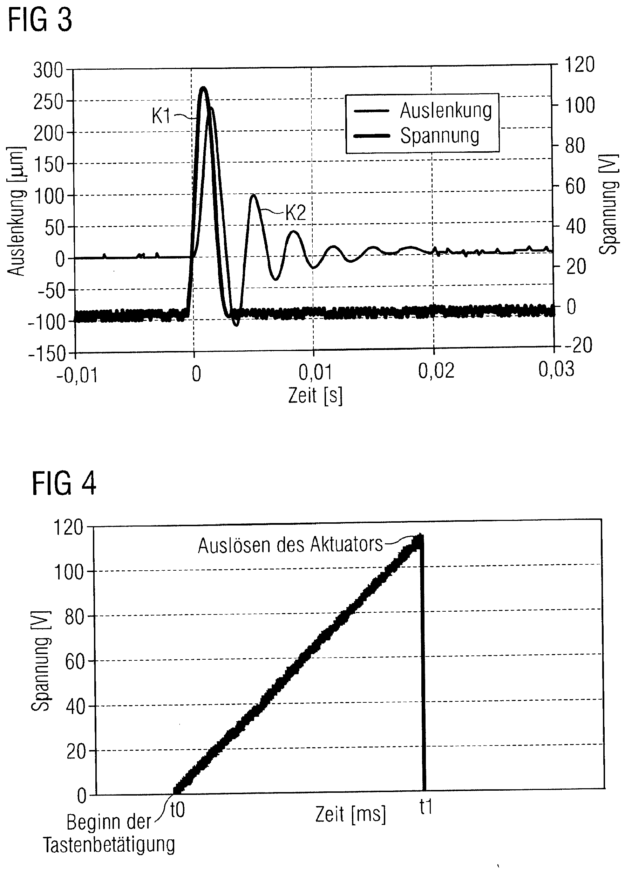

Figur 3 zeigt das Verhalten des piezoelektrischen Aktuators 4, das sich bei Anlegen eines einzelnen halbsinusförmigen Impulses ergibt.

Die Kurve K1 zeigt dabei den Verlauf der von der Treiberschaltung 10 an den piezoelektrischen Aktuator 4 angelegten Spannung. Die Spannung weist einen einzelnen halbsinusförmigen Impuls auf, der eine Pulsweite von 3,3 ms, also einer Frequenz von etwa 300 Hz, aufweist. Auf der Abszissenachse ist in Figur 3 die Zeit in Sekunden aufgetragen. Auf der Ordinatenachse ist in Bezug auf Kurve K1 die Höhe der angelegten Spannung in V aufgetragen.

Die Kurve K2 zeigt den Verlauf der Auslenkung der Verstärkungselemente 5, 6 in Folge der an den Aktuator 4 angelegten Spannung. Auf der Abszissenachse ist in Figur 3 die Zeit in Sekunden aufgetragen. Auf der Ordinatenachse ist in Bezug auf Kurve K1 die Auslenkung der an dem piezoelektrischen Aktuator 4 befestigten Verstärkungselemente 5, 6 in die zweite Richtung R2 in µm aufgetragen.

Es ist zu sehen, dass eine maximale Auslenkung von etwa 250 µm nach etwa 5 ms erreicht wird. Dementsprechend weist die Vorrichtung 1 eine sehr geringe Ansprechzeit auf. Die geringe Ansprechzeit von weniger als 10 ms ergibt sich aus der Verwendung des piezoelektrischen Aktuators 4 zur Erzeugung der haptischen Rückmeldung.

Nach einem Abfall der angelegten Spannung auf 0 V zeigt der piezoelektrische Aktuator 4 ein Abschwingverhalten. Die Amplitude seiner Längenänderung und damit auch die Amplitude der Bewegung der Verstärkungselemente 5, 6 nehmen kontinuierlich ab. Nach etwa 0,02 s ist die Vibration des Aktuators 4 vollständig abgeklungen.

Insgesamt führt der piezoelektrische Aktuator 4 in Reaktion auf den angelegten Spannungspuls eine kurze Vibration aus. Die Amplitude der kurzen Vibration nimmt kontinuierlich ab. Die von dem Aktuator 4 ausgeführte Vibration wird von einem Nutzer, der auf die Mensch-Maschine-Schnittstelle 2 drückt, als haptische Rückmeldung wahrgenommen. Insbesondere erscheint es für den Nutzer, der auf die Bedienoberfläche 3 der Mensch-Maschine-Schnittstelle 2 drückt, so, als ob ein mechanischer Widerstand der Mensch-Maschine-Schnittstelle 2 kurzzeitig abgenommen hätte. Dementsprechend entsteht für den Nutzer der Eindruck eines Kraftsprungs.

Figur 4 zeigt einen Sägezahnimpuls, der als elektrische Spannung an den Aktuator 4 angelegt werden kann. Auf der Abszissenachse ist dabei die Zeit in Sekunden aufgetragen und auf der Ordinatenachse die zum jeweiligen Zeitpunkt angelegte Spannung in Volt. Zum Zeitpunkt t₀ wird eine Betätigung der Mensch-Maschine-Schnittstelle 2 erkannt. Beispielsweise kann die Messeinheit 9 erkennen, dass eine Kraft auf die Mensch-Maschine-Schnittstelle 2 ausgeübt wird. Die Kraft ist in dem hier gezeigten Beispiel zum Zeitpunkt t₀ geringer als eine vordefinierte Kraftschwelle. Nunmehr wird an den Aktuator 4 von der Treiberschaltung 10 eine elektrische Spannung angelegt.

In dem hier gezeigten Beispiel wird die von einem Nutzer auf die Mensch-Maschine-Schnittstelle 2 ausgeübte Kraft langsam erhöht bis sie zum Zeitpunkt t₀ die vordefinierte Kraftschwelle übersteigt. Die von der Treiberschaltung 10 an den Aktuator 4 angelegte Spannung wird zwischen den Zeitpunkten t₀ und t₁ kontinuierlich erhöht. Dabei ändert sich die Länge des piezoelektrischen Aktuators 4 mit einer geringen Geschwindigkeit. Dementsprechend wird der Aktuator 4 nur zu sehr leichten Vibrationen angeregt.

Zum Zeitpunkt t₁ überschreitet die auf den Aktuator 4 ausgeübte Kraft die vordefinierte Kraftschwelle. Die Messeinheit 9 überwacht die auf die Mensch-Maschine-Schnittstelle 2 ausgeübte Kraft. Zum Zeitpunkt t₁ wird die von der Treiberschaltung 10 angelegte Spannung sprungartig auf null gesetzt. Dadurch wird, ähnlich wie bei dem in Figur 3 gezeigten kurzen halbsinusförmigen Impuls, eine starke Längenänderung des piezoelektrischen Aktuators 4 und damit verbunden eine deutlich ausgeprägte Bewegung der Verstärkungselemente **5,** 6 ausgelöst, wodurch eine haptische Rückmeldung für einen auf die Mensch-Maschine-Schnittstelle 2 drückenden Nutzer erzeugt wird.

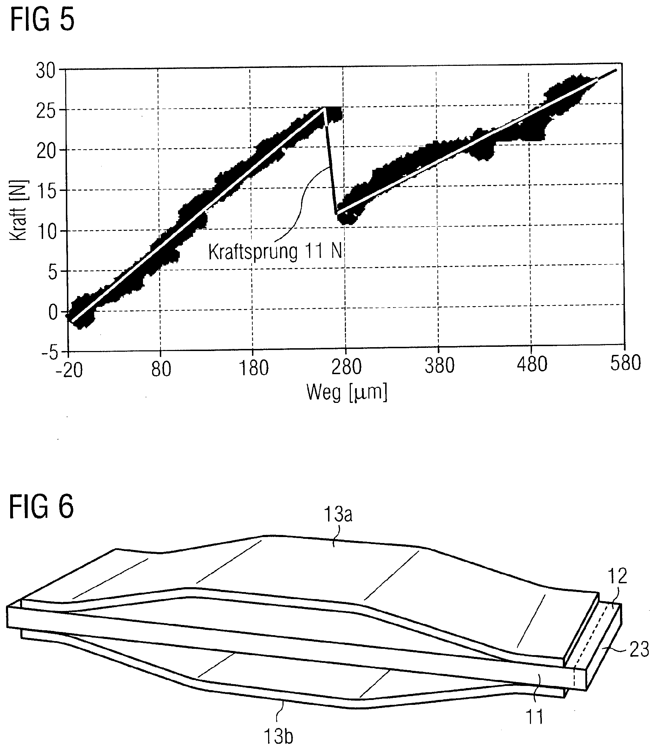

In Figur 5 ist ein Kraft-Weg-Diagramm dargestellt, das zeigt, wie der Nutzer die Betätigung der Mensch-Maschine-Schnittstelle 2 wahrnimmt. Auf der Ordinatenachse ist dabei die Kraft gezeigt, der von dem Nutzer gemäß seiner eigenen Empfindung auf die Mensch-Maschine-Schnittstelle ausgeübt wird. Auf der Abszissenachse ist der Weg dargestellt, um den die Schnittstelle gemäß der Empfindung des Nutzers bewegt wird.

Die vordefinierte Kraftschwelle liegt hier bei 25 **N.** Wird die Kraftschwelle erreicht, so wird der Aktuator 4 kurzzeitig in Vibration versetzt. Diese Vibration nimmt der Nutzer als Kraftsprung wahr. Für den Nutzer erscheint es so, als ob die von ihm auf die Mensch-Maschine-Schnittstelle 2 ausgeübte Kraft abnimmt. Drückt der Nutzer dann weiter auf die Mensch-Maschine-Schnittstelle 2 so scheint die ausgeübte Kraft wieder anzusteigen. Das Kraft-Weg-Diagramm, das in Figur 5 gezeigt ist, ähnelt sehr stark dem Kraft-Weg-Diagramm, das bei Betätigung einer mechanischen Taste auftritt und das in Figur 1 zu sehen ist. Durch den Kraftsprung kann dem Nutzer klar signalisiert werden, dass die Mensch-Maschine-Schnittstelle 2 betätigt wurde. Das haptische Verhalten einer mechanischen Taste kann somit durch die Vorrichtung 1 exakt nachgebildet werden. Der Benutzer erfährt das von ihm intuitiv erwartete Gefühl. Eine Irritation des Benutzers wird somit vermieden und das Benutzungserlebnis wird generell gesteigert.

In einer alternativen Ausführungsform kann bei Erreichen der Kraftschwelle eine rechteckförmige Spannung an den Aktuator 4 angelegt werden. Dabei wird die Spannung sprungartig erhöht, so dass eine haptische Rückmeldung für den Nutzer erzeugt wird. Die angelegte Spannung bleibt kontinuierlich angelegt, bis die Messeinheit 9 erkennt, dass die auf die Mensch-Maschine-Schnittstelle 2 ausgeübte Kraft die Kraftschwelle unterschreitet. Dann wird die Spannung sprungartig abgebaut, wodurch es erneut zu einer Vibration des Aktuators 4 und damit verbunden zu einer haptischen Rückmeldung kommt. Für den Nutzer ergibt sich dadurch das Gefühl des Loslassens einer mechanischen Taste. Wiederum wird ein Kraftsprung durch die haptische Rückmeldung nachgebildet.

Die Treiberschaltung 10 kann dazu ausgelegt sein, eine elektrische Spannung in einer beliebigen Form an den piezoelektrischen Aktuator 4 anzulegen. Wesentlich für die Erzeugung einer haptischen Rückmeldung ist, dass die angelegte Spannung innerhalb eines kurzen Zeitraums wesentlich geändert wird. Beispielsweise kann die angelegte Spannung die Form eines einzelnen Sinusimpulses, eines einzelnen Rechteckimpulses, eines einzelnen Sägezahnimpulses, eines einzelnen Halb-Sinusimpulses eines einzelnen Halb-Rechteckimpulses oder eines einzelnen Halb-Sägezahnimpulses aufweisen.

Die hier beschriebene Vorrichtung 1 ermöglicht es somit die Vorteile einer rein mechanischen Taste mit den Vorteilen rein elektronischer Mensch-Maschine-Schnittstellen, beispielsweise Touch-Bildschirmen, zu kombinieren. Ein wesentlicher Vorteil der rein mechanischen Taste besteht in dem Kraftsprung der bei Betätigung der Taste auftritt und dem Nutzer eine zuverlässige Rückmeldung einer erfolgreichen Betätigung vermittelt. Die Vorteile rein elektronischer Mensch-Maschine-Schnittstellen liegen beispielsweise darin, dass diese preisgünstiger und vielseitiger sind. Zudem lassen sich pflegeleichte, optisch ansprechende Bedienoberflächen realisieren. Die vorliegende Vorrichtung ermöglicht es, den Nachteil von rein elektronischen Mensch-Maschine-Schnittstellen zu überwinden, dass es für einen Nutzer bei diesen nicht ohne weiteres zu erkennen ist, ob er eine bestimmt Taste erfolgreich betätigt hat oder nicht.

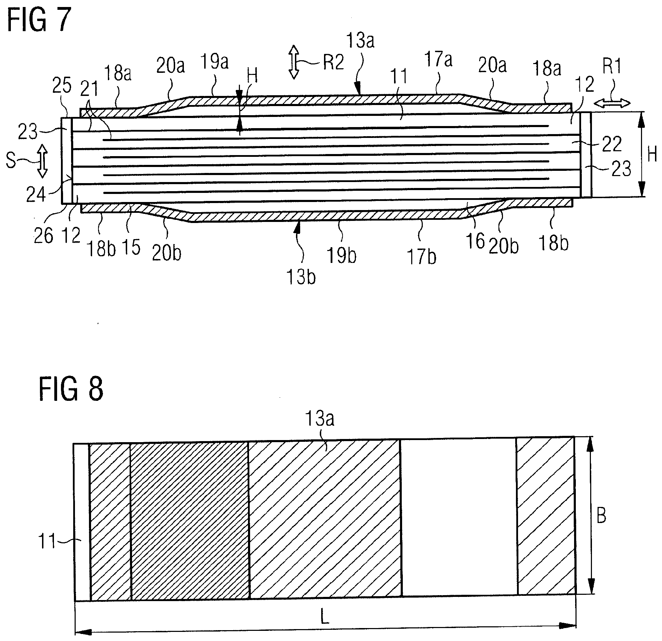

Die Figuren 6 und 7 zeigen einen alternativen piezoelektrischen Aktuator 11 mit zwei Verstärkungselementen 13a, 13b auf, der statt dem in Figur 2 gezeigten Aktuator 4 mit den zwei in Figur 2 gezeigten Verstärkungselementen 5, 6 verwendet werden kann.

Der in Figur 2 gezeigte piezoelektrische Aktuator 4 weist eine quadratische Grundfläche auf. Die zugehörigen Verstärkungselemente 5, 6 sind kegelstumpfförmig.

Der in den Figuren 6 und 7 gezeigte piezoelektrische Aktuator 11 weist dagegen eine rechteckige Grundfläche auf. Seine Länge L ist dabei größer als seine Breite B, wobei die Länge L die längere Seite der rechteckigen Grundfläche bezeichnet und die Breite B die kürzere Seite der rechteckigen Grundfläche bezeichnet. Beispielsweise kann das Verhältnis Länge L zu Breite B zwischen 2:1 und 20:1 betragen. Die Verstärkungselemente 13a, 13b sind Metallbügel. Die Verstärkungselemente 13a, 13b können Titan aufweisen oder aus Titan bestehen.

Der in Figur 6 und Figur 7 gezeigte piezoelektrische Aktuator 11 ermöglicht es, höhere Kräfte und höhere Beschleunigungen zu erzeugen als der in Figur 2 gezeigte piezoelektrische Aktuator **4.** Im Folgenden werden der piezoelektrische Aktuator 11 und die zugehörigen Verstärkungselemente 13a, 13b im Detail beschrieben.

Figur 6 zeigt den piezoelektrischen Aktuator 11 und die zugehörigen Verstärkungselemente 13a, 13b in perspektivischer Ansicht. Figur 7 zeigt eine Seitenansicht des piezoelektrischen Aktuators 11 und der zugehörigen Verstärkungselemente 13a, 13b. Ferner zeigt Figur 8 eine Draufsicht auf die Oberseite des Verstärkungselements 13a und des Aktuators 11.

Der piezoelektrische Aktuator 11 weist einen Stapel aus in einer Stapelrichtung S abwechselnd übereinandergestapelten Innenelektroden 21 und piezoelektrischen Schichten 22 auf. Der piezoelektrische Aktuator 11 weist eine erste Außenelektrode 23, die auf einer ersten Stirnfläche 24 angeordnet ist, und eine zweite Außenelektrode 23, die auf einer zweiten Stirnfläche angeordnet ist, auf. Die Innenelektroden 21 sind in Stapelrichtung S abwechselnd mit der ersten Außenelektrode 23 oder mit der zweiten Außenelektrode 23 kontaktiert.

Bei den piezoelektrischen Schichten 22 kann es sich um Blei-Zirkonat-Titanat-Keramiken (PZT-Keramiken) handeln. Die PZT-Keramik kann ferner zusätzlich Nd und Ni enthalten. Alternativ kann die PZT-Keramik ferner zusätzlich Nd, K und gegebenenfalls Cu aufweisen. Alternativ können die piezoelektrischen Schichten 22 eine Pb(ZrₓTi₁₋ₓ)O₃ + y Pb(Mn_{1/3}Nb_{2/3})O₃ enthaltenden Zusammensetzung aufweisen.

Die Innenelektroden 21 weisen Kupfer auf oder bestehen aus Kupfer.

Der piezoelektrische Aktuator 11 ist quaderförmig. Als Grundfläche wird dabei eine Fläche bezeichnet, deren Flächennormale in die Stapelrichtung S weist. Die Grundfläche ist rechteckig. Die längere Seite der Grundfläche definiert die Länge L des piezoelektrischen Aktuators 11 und die kürzere Seite der Grundfläche definiert die Breite B des piezoelektrischen Aktuators 11.

Der piezoelektrische Aktuator 11 weist eine Länge L zwischen 5 mm und 20 mm sowie eine Breite B zwischen 2 mm und 8 mm auf. Gemäß einem ersten Ausführungsbeispiel weist der piezoelektrische Aktuator 11 eine Länge L von 12 mm und eine Breite B von 4 mm auf. In einem zweiten Ausführungsbeispiel weist der piezoelektrische Aktuator 11 eine Länge L von 9 mm und eine Breite B von 3,75 mm auf.

Die Ausdehnung des piezoelektrischen Aktuators in Stapelrichtung S definiert die Höhe H des piezoelektrischen Aktuators 11. Die Höhe H des piezoelektrischen Aktuators 11 kann zwischen 200 µm und 1000 µm liegen. Beispielsweise beträgt die Höhe H in dem ersten und dem zweiten Ausführungsbeispiel jeweils 500 µm.

Der Aktuator 11 weist zwei Isolationsbereiche 12 auf. Der jeweilige Isolationsbereich 12 ist in einem Endbereich des Aktuators 11 ausgebildet. Insbesondere ist der jeweilige Isolationsbereich 12 im Bereich einer Stirnfläche 24 des Aktuators ausgebildet.

Im Isolationsbereich 12 reichen nur Innenelektroden 21 einer Polarität bis an die Stirnfläche 24 des Aktuators 11. Der Isolationsbereich 12 kann zur Kontaktierung des Aktuators 11 verwendet werden. Beispielsweise kann der jeweilige Isolationsbereich 12 mit den Außenelektroden 23 zur elektrischen Kontaktierung versehen werden.

Der Aktuator 11 ist so ausgestaltet, dass bei Anlegen einer elektrischen Spannung eine Verformung des Aktuators 11 stattfindet (Ausdehnung in eine erste Richtung R1). Insbesondere sind die piezoelektrischen Schichten 22 derart polarisiert, dass das Anlegen einer elektrischen Spannung zwischen den Innenelektroden 21 zu einer Querkontraktion des Aktuators 11 führt, bei der sich die Länge L des Aktuators 11 senkrecht zur Stapelrichtung S verändert. Folglich erfolgt eine Ausdehnung des Aktuators quer zur Polarisationsrichtung und zum elektrischen Feld (d31 Effekt).

Um den Effekt der Längenänderung in Stapelrichtung S weiter zu verstärken weist die Vorrichtung die zwei Verstärkungselemente 13a, 13b auf. Wird an den Aktuator 11 eine Spannung angelegt, so verformen sich die Verstärkungselemente 13a, 13b zumindest teilweise in Folge der Änderung der Ausdehnung des Aktuators 11, wie später im Detail beschrieben wird. Insbesondere sind die beiden Verstärkungselemente 13a, 13b derart dimensioniert und mit dem Aktuator 11 verbunden, dass je ein Teilbereich 17a, 17b der Verstärkungselemente 13a, 13b in Folge einer Änderung der Länge L des Aktuators eine Hubbewegung in die Stapelrichtung S ausführt, wobei die Amplitude der Hubbewegung größer ist als die Amplitude der Änderung der Länge L des Aktuators.

Der Aktuator 11 ist zwischen den Verstärkungselementen 13a, 13b angeordnet. Die Verstärkungselemente 13a, 13b liegen zumindest teilweise auf der Oberseite 25 bzw. einer Unterseite 26 des Aktuators 11 auf.

Das jeweilige Verstärkungselement 13a, 13b ist einstückig ausgebildet. Das jeweilige Verstärkungselement 13a, 13b weist eine rechteckige Form auf. Das jeweilige Verstärkungselement 13a, 13b ist streifenförmig ausgebildet. Das jeweilige Verstärkungselement 13a, 13b ist gekrümmt bzw. verbogen ausgebildet. Das jeweilige Verstärkungselement 13a, 13b ist bügelförmig. Beispielsweise weist das jeweilige Verstärkungselement einen Blechstreifen auf. Das jeweilige Verstärkungselement weist Titan auf oder besteht aus Titan. Der Blechstreifen ist gebogen, wie im Folgenden im Detail erläutert wird.

Jedes der einstückigen Verstärkungselemente 13a, 13b ist in mehrere Bereiche oder Abschnitte untergliedert. So weist das jeweilige Verstärkungselement 13a, 13b einen Teilbereich oder ersten Bereich 17a, 17b auf. Der Teilbereich 17a, 17b weist jeweils einen ersten Abschnitt oder mittleren Bereich 19a, 19b auf.

Der Teilbereich 17a, 17b weist ferner jeweils zwei zweite Abschnitte oder Verbindungsbereiche 20a, 20b auf. Die beiden Verbindungsbereiche 20a, 20b des jeweiligen Verstärkungselements 13a, 13b schließen sich unmittelbar an den mittleren Bereich 19a, 19b des jeweiligen Verstärkungselements 13a, 13b an. Der mittlere Bereich 19a, 19b des jeweiligen Verstärkungselements 13a, 13b ist mit anderen Worten von den beiden Verbindungsbereichen 20a, 20b zu beiden Seiten hin umgeben.

Das jeweilige Verstärkungselement 13a, 13b weist ferner zwei Endbereiche 18a, 18b auf. Die Endbereiche 18a, 18b schließen sich unmittelbar an die Verbindungsbereiche 20a, 20b des jeweiligen Verstärkungselements 13a, 13b an. Mit andere Worten verbindet jeweils ein Verbindungsbereich 20a, 20b einen Endbereich 18a, 18b mit dem mittleren Bereich 19a, 19b eines Verstärkungselements 13a, 13b.

Die beiden Endbereiche 18a, 18b des jeweiligen Verstärkungselements liegen unmittelbar auf einer Oberfläche des Aktuators 11 auf. So liegen der erste und der zweite Endbereich 18a des ersten Verstärkungselements 13a auf einem Teilbereich der Oberseite 25 des Aktuators 11 auf. Weiterhin liegen der erste und der zweite Endbereich 18b des zweiten Verstärkungselements 13b auf einem Teilbereich der Oberseite 25 oder der Unterseite 26 des Aktuators 11 auf.

Die Endbereiche 18a, 18b sind vorzugsweise unlösbar mit der Oberfläche des Aktuators 11 verbunden. Insbesondere sind die Endbereiche 18a, 18b mit der Oberfläche des Aktuators 11 durch eine Klebeverbindung 15 verbunden.

Der jeweilige Teilbereich 17a, 17b ist von der Oberfläche des Aktuators 11 beabstandet. Insbesondere befindet sich zwischen dem jeweiligen Teilbereich 17a, 17b und der Unterseite 26 bzw. der Oberseite 25 des Aktuators 11 ein Freibereich 16. Der Freibereich 16 weist eine Höhe h auf. Eine freie Höhe h zwischen dem Aktuator 11 und dem Teilbereich 17a, 17b liegt zwischen 0,2 mm und 2,0 und beträgt in dem ersten Ausführungsbeispiel 0,75 mm und in dem zweiten Ausführungsbeispiel 0,4 mm, wobei die freie Höhe h den maximalen Abstand zwischen dem Teilbereich 17a, 17b und dem piezoelektrischen Aktuator 11 angibt, wenn keine Spannung an dem Aktuator 11 anliegt und keine äußere Kraft auf das Verstärkungselement 13a, 13b wirkt.

Die Höhe h des Freibereichs 16 variiert entlang des jeweiligen Teilbereichs 17a, 17b. So ist der mittlere Bereich 19a, 19b des jeweiligen Teilbereichs 17a, 17b so ausgebildet, dass er parallel zu der Oberfläche des Aktuators 11 verläuft. Damit ist die Höhe h des Freibereichs 16 im Bereich des mittleren Bereichs 19a, 19b maximal. Der jeweilige Verbindungsbereich 20a, 20b verläuft hingegen schräg zur Oberfläche des Aktuators 11. Mit anderen Worten der jeweilige Verbindungsbereich 20a, 20b schließt einen Winkel mit der Oberseite 25 bzw. der Unterseite 26 des Aktuators 11 ein. Der Winkel ist vorzugsweise kleiner oder gleich 45°. Damit verkleinert sich die Höhe h des Freibereichs 16 in Richtung von mittleren Bereich 19a, 19b hin zum Endbereich 18a, 18b des jeweiligen Verstärkungselements 13a, 13b. Folglich weist das jeweilige Verstärkungselement 13a, 13b eine gebogene Form auf.

Das jeweilige Verstärkungselement 13a, 13b kann in alternativen, hier nicht gezeigten Ausführungsformen wenigstes eine Ausdünnung, vorzugsweise mehrere Ausdünnungen, zwischen den jeweiligen Bereichen des Verstärkungselements aufweisen.

Bei den mechanischen Verstärkungselementen 13a, 13b kann es sich jeweils um ein Titanblech handeln, das eine Dicke zwischen 0,1 mm und 0,4 mm aufweist. Beispielsweise kann das Blech eine Dicke von 0,2 mm aufweisen. Bei Blechdicken in dem hier genannten Bereich kann eine Verformung des Blechs, die zur Ausführung einer Hubbewegung erforderlich ist, mit einer geringen Kraft herbeigeführt werden. Es kann daher darauf verzichtet werden, die Verformbarkeit des Blechs durch Ausdünnungen zu erhöhen. Dementsprechend kann das Blech frei von Ausdünnungen oder Einkerbungen sein.

Der flache mittlere Bereich 19a, 19b des jeweiligen Verstärkungselementes 13a, 13b kann eine Länge zwischen 1,5 mm und 5,0 mm aufweisen. Im ersten Ausführungsbeispiel ist der mittlere Bereich 19a, 19b 3,5 mm lang. Im zweiten Ausführungsbeispiel 19a, 19b ist der mittlere Bereich 2,5 mm lang. Die Endbereiche 18a, 18b können eine Länge zwischen 1,0 mm und 0,5 mm aufweisen. Im ersten und im zweiten Ausführungsbeispiel sind die Endbereiche 18a, 18b jeweils 0,7 mm lang. Eine geringere Länge als 0,5 mm sollte nicht gewählt werden, da ansonsten die Klebeverbindung 15 zwischen den Endbereichen 18a, 18b und dem Aktuator 11 möglicherweise nicht ausreichend stark ausgebildet werden kann.

Eine Gesamthöhe des Bauteils bestehend aus dem Aktuator 11 und den beiden Verstärkungselementen 13a, 13b kann zwischen 5,0 mm und 1,0 mm liegen. In dem ersten Ausführungsbeispiel beträgt die Gesamthöhe 2,4 **mm.** In dem zweiten Ausführungsbeispiel beträgt die Gesamthöhe 1,7 mm.

Für den Einsatz des piezoelektrischen Aktuators 11 und der Verstärkungselemente 13a, 13b in elektronischen Geräten ist Miniaturisierung ein wesentlicher Gesichtspunkt. Durch die Verwendung der hier beschriebenen Bauteile mit den angegebenen Dimensionen werden Bauteile bereitgestellt, die ein haptisches Signal erzeugen und dabei nur einen sehr geringen Platzbedarf aufweisen. Ein Bauteil mit den oben angegebenen Dimensionen kann beispielsweise unter einer Bedienoberfläche eines Mobiltelefons oder eines Uhrengehäuses platziert werden.

Bei einer angelegten Spannung von 60 V ergibt sich in dem ersten Ausführungsbeispiel eine freie Auslenkung, beziehungsweise ein Hub, von 25 µm und eine Blockierkraft von 3,5 **N.** Die Steifigkeit beträgt dabei 0,14 N/µm. Im zweiten Ausführungsbeispiel ergibt sich bei einer angelegten Spannung von 60 V eine freie Auslenkung, beziehungsweise ein Hub, von 15 µm und eine Blockierkraft von 2,5 **N.** Die Steifigkeit beträgt dabei 0,16 N/µm.

Wird nun an den Aktuator 11 Spannung angelegt, so bewegen sich die Teilbereiche 17a, 17b des jeweiligen Verstärkungselements 13a, 13b relativ zum Aktuator 11 in eine zweite Richtung R2. Die zweite Richtung R2 ist senkrecht zur ersten Richtung R1. Die zweite Richtung R2 verläuft entlang der Stapelrichtung **S.**

Insbesondere bewegen sich die mittleren Bereiche 19a, 19b in die zweite Richtung R2. Dabei biegt sich das jeweilige Verstärkungselement 13a, 13b an Übergängen zwischen mittlerem Bereich 19a, 19b und Verbindungsbereichen 20a, 20b sowie zwischen Verbindungsbereichen 20a, 20b und Endbereichen 18a, 18b.

Hingegen wird eine Bewegung der Endbereiche 18a, 18b in die zweite Richtung R2 durch die Klebeverbindung 15 mit dem Aktuator 11 verhindert. Vielmehr bewegen sich die Endbereiche 18a, 18b mit dem Aktuator 11 in die erste Richtung R1. Es findet damit eine Relativbewegung zwischen den Endbereichen 18a, 18b und den Teilbereichen 17a, 17b statt.

### Bezugszeichenliste

- 1: Vorrichtung
- 2: Mensch-Maschine-Schnittstelle
- 3: Bedienoberfläche
- 4: piezoelektrischer Aktuator
- 4a: Oberseite des piezoelektrischen Aktuators
- 4b: Unterseite des piezoelektrischen Aktuators
- 5: erste Verstärkungselement
- 5a: Randbereich
- 5b: mittlerer Bereich
- 6: zweite Verstärkungselement
- 6a: Randbereich
- 6b: mittlerer Bereich
- 7: Grundplatte
- 8: Feder
- 9: Messeinheit
- 10: Treiberschaltung
- 11: Piezoelektrischen Aktuator
- 12: Isolationsbereich
- 13a: Verstärkungselement
- 13b: Verstärkungselement
- 15: Klebeverbindung
- 16: Freibereich
- 17a, 17b: Teilbereich
- 18a, 18b: Endbereich
- 19a, 19b: Erster Abschnitt des Teilbereichs / mittlerer Bereich
- 20a, 20b: Zweiter Abschnitt des Teilbereichs / Verbindungsbereich
- 21: Innenelektrode
- 22: Piezoelektrische Schicht
- 23: Außenelektrode
- 24: Stirnfläche
- 25: Oberseite
- 26: Unterseite

- SP: Schaltpunkt
- R1: erste Richtung
- R2: zweite Richtung
- K1: Verlauf der angelegten Spannung
- K2: Verlauf der Auslenkung der Verstärkungselemente
- B: Breite des Aktuators
- h: Höhe des Freibereichs
- H: Höhe des Aktuators
- L: Länge des Aktuators
- R1: Erste Richtung
- R2: Zweite Richtung
- S: Stapelrichtung

## Patentansprüche

1. Vorrichtung (1) zur Erzeugung einer aktiven haptischen Rückmeldung, aufweisend:
- wenigstens einen piezoelektrischen Aktuator (4, 11) aufweisend eine Vielzahl von piezoelektrischen Schichten und dazwischen angeordnete Innenelektroden,
- ein erstes Verstärkungselement (5, 13a) und ein zweites Verstärkungselement (6, 13b), wobei der piezoelektrische Aktuator (4, 11) zwischen den Verstärkungselementen (5, **6,** 13a, 13b) angeordnet ist, wobei der piezoelektrische Aktuator (4, 11) dazu ausgebildet und angeordnet ist, seine Ausdehnung bei Anlegen einer elektrischen Spannung in eine erste Richtung (R1) zu verändern und wobei die Verstärkungselemente (5, **6,** 13a, 13b) dazu ausgebildet und angeordnet sind, sich in Folge der Änderung der Ausdehnung des piezoelektrischen Aktuators (4, 11) derart zu verformen, dass ein Teilbereich (5b, 6b) des jeweiligen Verstärkungselements (5, **6,** 13a, 13b) relativ zu dem piezoelektrischen Aktuator (4) in eine zweite Richtung (R2), die senkrecht zur ersten Richtung (R1) ist, bewegt wird, und
- eine Treiberschaltung (10), die dazu ausgestaltet ist, eine elektrische Spannung an den piezoelektrischen Aktuator (4, 11) anzulegen, so dass die Verstärkungselemente (5, **6,** 13a, 13b) derart verformt werden, dass gegenüber einem auf die Vorrichtung (1) drückenden Objekt eine haptische Rückmeldung erzeugt wird, die einen Kraftsprung nachbildet,
**dadurch gekennzeichnet dass**
die Treiberschaltung (10) dazu ausgelegt ist, die elektrische Spannung derart an den piezoelektrischen Aktuator (4, 11) anzulegen, dass die angelegte Spannung zunächst kontinuierlich zunimmt, wenn auf die Vorrichtung (1) eine Kraft ausgeübt wird, und dass die angelegte Spannung sprungartig abnimmt, wenn die auf die Vorrichtung (1) ausgeübte Kraft eine Kraftschwelle überschreitet.

2. Vorrichtung (1) gemäß dem vorherigen Anspruch,
wobei die Treiberschaltung (10) dazu ausgelegt ist, eine elektrische Spannung an den piezoelektrischen Aktuator (4, 11) anzulegen, die die Form eines einzelnen Sinusimpulses, eines einzelnen Rechteckimpulses, eines einzelnen Sägezahnimpulses, eines einzelnen Halb-Sinusimpulses, eines einzelnen Halb-Rechteckimpulses, eines einzelnen Halb-Sägezahnimpulses, mehrerer Sinusimpulse, mehrerer Rechteckimpulse, mehrerer Sägezahnimpulse, mehrerer Halb-Sinusimpulse, mehrerer Halb-Rechteckimpulse oder mehrerer Halb-Sägezahnimpulse hat.

3. Vorrichtung (1) gemäß einem der vorherigen Ansprüche, wobei die Vorrichtung (1) dazu ausgestaltet ist, eine auf die Vorrichtung (1) ausgeübte Kraft zu erkennen.

4. Vorrichtung (1) gemäß einem der vorherigen Ansprüche, wobei die Vorrichtung (1) dazu ausgestaltet ist, eine zwischen den Innenelektroden des piezoelektrischen Aktuators (4, 11) erzeugte Spannung, die in Folge einer auf die Vorrichtung (1) ausgeübten Kraft entsteht, zu erkennen und
wobei die Vorrichtung (1) dazu ausgestaltet ist, anhand der Höhe der zwischen den Innenelektroden erzeugten Spannung die auf die Vorrichtung (1) ausgeübte Kraft zu erkennen.

5. Vorrichtung (1) gemäß einem der vorherigen Ansprüche, wobei die Vorrichtung (1) dazu ausgestaltet ist, die aktive haptische Rückmeldung dadurch zu erzeugen, dass zwischen den Innenelektroden des piezoelektrischen Aktuators (4, 11) eine elektrische Spannung angelegt wird, die zu einer Längenänderung des Aktuators (4) führt.

6. Vorrichtung (1) gemäß einem der vorherigen Ansprüche, wobei die Vorrichtung (1) dazu ausgestaltet ist, die haptische Rückmeldung zu erzeugen, die den Kraftsprung nachbildet, indem die an den piezoelektrischen Aktuator (4, 11) angelegte Spannung sprungartig verändert wird, wodurch der piezoelektrische Aktuator (4, 11) in eine Vibration versetzt wird.

7. Vorrichtung (1) gemäß dem vorherigen Anspruch,
wobei eine Frequenz der Vibration in einem Bereich von 10 Hz bis 500 Hz liegt, vorzugsweise in einem Bereich von 10 Hz bis 100 Hz oder in einem Bereich von 250 Hz bis 500 Hz.

8. Vorrichtung (1) gemäß einem der vorherigen Ansprüche, wobei das erste Verstärkungselement (5) ein kegelstumpfförmiges Blech aufweist und wobei das zweite Verstärkungselement (6) ein kegelstumpfförmiges Blech aufweist.

9. Vorrichtung (1) gemäß dem vorherigen Anspruch,
wobei die kegelstumpfförmigen Bleche jeweils einen Randbereich (5a, 6a) aufweisen, der auf einer Oberseite (4a) bzw. einer Unterseite (4b) des piezoelektrischen Aktuators (4) befestigt ist, und
wobei die kegelstumpfförmigen Bleche jeweils einen mittleren Bereich (5b, 6b) aufweisen, der in von der Oberseite (4a) bzw. der Unterseite (4b) absteht und der den Teilbereich bildet, der dazu ausgestaltet ist, in die zweite Richtung (R2) bewegt zu werden.

10. Vorrichtung (1) gemäß einem der Ansprüche 8 oder 9, wobei die Bleche jeweils Titan aufweisen.

11. Vorrichtung (1) gemäß dem vorherigen Anspruch,
wobei das mechanische Verstärkungselement (13a, 13b) ein Metallbügel ist.

12. Vorrichtung (1) gemäß einem der vorherigen Ansprüche, wobei das mechanische Verstärkungselement (13a, 13b) frei von Einkerbungen ist und eine konstante Wandstärke aufweist,
oder
wobei das mechanische Verstärkungselement (13a, 13b) zumindest eine Einkerbung aufweist, die einen mechanischen Widerstand gegen eine Verformung des mechanischen Verstärkungselements reduziert.

13. Vorrichtung (1) gemäß einem der vorherigen Ansprüche, wobei der piezoelektrische Aktuator (4) eine quadratische Grundfläche aufweist, oder
wobei der piezoelektrische Aktuator (11) eine Grundfläche aufweist, deren Länge (L) größer ist als deren Breite (B).

14. Vorrichtung (1) gemäß einem der vorherigen Ansprüche, wobei die Vorrichtung (1) eine Grundplatte (7) und eine Mensch-Maschine-Schnittstelle (2), die dazu ausgestaltet ist, von dem Objekt betätigt zu werden, aufweist, und wobei der piezoelektrische Aktuator (4, 11) zwischen der Grundplatte (7) und der Mensch-Maschine-Schnittstelle (2) angeordnet ist.

15. Verfahren zur Erzeugung einer aktiven haptischen Rückmeldung mit einer Vorrichtung (1) gemäß einem der vorherigen Ansprüche,
wobei von der Treiberschaltung (10) eine an den piezoelektrischen Aktuator (4, 11) angelegte elektrische Spannung verändert wird, wenn eine auf die Vorrichtung (1) wirkende Kraft, eine Kraftschwelle überschreitet.

## Claims

1. Device (1) for producing active haptic feedback, comprising:
- at least one piezoelectric actuator (4, 11) having a plurality of piezoelectric layers and internal electrodes arranged therebetween,
- a first amplification element (5, 13a) and a second amplification element (6, 13b), wherein the piezoelectric actuator (4, 11) is arranged between the amplification elements (5, 6, 13a, 13b), wherein the piezoelectric actuator (4, 11) is designed and configured to change its extension in a first direction (R1) upon the application of an electrical voltage, and wherein the amplification elements (5, 6, 13a, 13b) are designed and configured to deform as a result of the change in the extension of the piezoelectric actuator (4, 11), such that a subregion (5b, 6b) of the respective amplification element (5, 6, 13a, 13b) is moved relative to the piezoelectric actuator (4) in a second direction (R2), which is perpendicular to the first direction (R1), and
- a driver circuit (10), which is configured to apply an electrical voltage to the piezoelectric actuator (4, 11), such that the amplification elements (5, 6, 13a, 13b) are deformed in such a manner that haptic feedback is produced against an object pressing on the device (1), said feedback imitating a jump in force,
**characterized in that**
the driver circuit (10) is designed to apply the electrical voltage to the piezoelectric actuator (4, 11), such that the voltage applied initially increases in a continuous manner, when a force is exerted on the device (1), and that the voltage applied decreases abruptly, when the force exerted on the device (1) exceeds a force threshold.

2. Device (1) according to the preceding claim, wherein the driver circuit (10) is designed to apply an electrical voltage to the piezoelectric actuator (4, 11), which has the form of a single sine pulse, a single square-wave pulse, a single saw-tooth pulse, a single half-sine pulse, a single half-square-wave pulse, a single half-saw-tooth pulse, a plurality of sine pulses, a plurality of square-wave pulses, a plurality of saw-tooth pulses, a plurality of half-sine pulses, a plurality of half-square-wave pulses or a plurality of half-saw-tooth pulses.

3. Device (1) according to either of the preceding claims,
wherein the device (1) is configured to detect a force which is exerted on the device (1).

4. Device (1) according to one of the preceding claims, wherein the device (1) is configured to detect a voltage which is generated between the internal electrodes of the piezoelectric actuator (4, 11) and which is produced as a result of a force exerted on the device (1), and wherein the device (1) is configured, by reference to the magnitude of the voltage generated between the internal electrodes, to detect the force exerted on the device (1).

5. Device (1) according to one of the preceding claims, wherein the device (1) is configured to generate the active haptic feedback, in that an electrical voltage is applied between the internal electrodes of the piezoelectric actuator (4, 11), which voltage results in a change in length of the actuator (4).

6. Device (1) according to one of the preceding claims, wherein the device (1) is configured to generate the haptic feedback which imitates the jump in force, by abruptly varying the voltage applied to the piezoelectric actuator (4, 11), as a result of which a vibration of the piezoelectric actuator (4, 11) is initiated.

7. Device (1) according to the preceding claim, wherein a frequency of the vibration lies in a range of 10 Hz to 500 Hz, preferably in a range of 10 Hz to 100 Hz, or in a range of 250 Hz to 500 Hz.

8. Device (1) according to one of the preceding claims, wherein the first amplification element (5) comprises a truncated cone-shaped plate, and wherein the second amplification element (6) comprises a truncated cone-shaped plate.

9. Device (1) according to the preceding claim, wherein the truncated cone-shaped plates respectively comprise an edge region (5a, 6a), which is fastened to an upper side (4a) or an underside (4b) of the piezoelectric actuator (4), and
wherein the truncated cone-shaped plates respectively comprise a central region (5b, 6b), which protrudes from the upper side (4a) or the underside (4b) and which forms the subregion which is configured to be moved in the second direction (R2).

10. Device (1) according to either of Claims 8 and 9, wherein the plates respectively comprise titanium.

11. Device (1) according to the preceding claim, wherein the mechanical amplification element (13a, 13b) is a metal bracket.

12. Device (1) according to one of the preceding claims, wherein the mechanical amplification element (13a, 13b) is free of indentations and has a constant wall thickness,
or
wherein the mechanical amplification element (13a, 13b) comprises at least one indentation, which reduces a mechanical resistance to deformation of the mechanical amplification element.

13. Device (1) according to one of the preceding claims, wherein the piezoelectric actuator (4) comprises a quadratic base surface, or
wherein the piezoelectric actuator (11) comprises a base surface, the length (L) of which is greater than its width (B).

14. Device (1) according to one of the preceding claims, wherein the device (1) comprises a base plate (7) and a man-machine interface (2), which is configured to be actuated by the object, and
wherein the piezoelectric actuator (4, 11) is arranged between the base plate (7) and the man-machine interface (2).

15. Method for producing active haptic feedback by means of a device (1) according to one of the preceding claims, wherein an electrical voltage which is applied to the piezoelectric actuator (4, 11) is varied by the driver circuit (10), when a force acting on the device (1) exceeds a force threshold.

## Revendications

1. Dispositif (1) destiné à générer une rétroaction haptique active, comprenant :
- au moins un actionneur piézoélectrique (4, 11) possédant une pluralité de couches piézoélectriques et des électrodes internes disposées entre celles-ci,
- un premier élément de renforcement (5, 13a) et un deuxième élément de renforcement (6, 13b), l'actionneur piézoélectrique (4, 11) étant disposé entre les éléments de renforcement (5, 6, 13a, 13b), l'actionneur piézoélectrique (4, 11) étant configuré et disposé pour modifier son expansion dans une première direction (R1) lors de l'application d'une tension électrique, et les éléments de renforcement (5, 6, 13a, 13b) étant configurés et disposés pour se déformer en conséquence de la modification de l'expansion de l'actionneur piézoélectrique (4, 11) de telle sorte qu'une zone partielle (5b, 6b) de l'élément de renforcement (5, 6, 13a, 13b) respectif est déplacée par rapport à l'actionneur piézoélectrique (4) dans une deuxième direction (R2) qui est perpendiculaire à la première direction (R1), et
- un circuit d'attaque (10), qui est configuré pour appliquer une tension électrique à l'actionneur piézoélectrique (4, 11) de telle sorte que les éléments de renforcement (5, 6, 13a, 13b) soient déformés de telle sorte qu'une rétroaction haptique qui simule un saut de force soit générée par rapport à un objet appuyant sur le dispositif (1),
**caractérisé en ce que**
le circuit d'attaque (10) est conçu pour appliquer la tension électrique à l'actionneur piézoélectrique (4, 11) de telle sorte que la tension appliquée augmente tout d'abord de manière continue lorsqu'une force est exercée sur le dispositif (1) et que la tension appliquée diminue brusquement lorsque la force exercée sur le dispositif (1) dépasse un seuil de force.

2. Dispositif (1) selon la revendication précédente, le circuit d'attaque (10) est conçu pour appliquer une tension électrique à l'actionneur piézoélectrique (4, 11), laquelle se présente sous la forme d'une impulsion sinusoïdale unique, d'une impulsion rectangulaire unique, d'une impulsion en dents de scie unique, d'une impulsion demi-sinusoïdale unique, d'une impulsion demi-rectangulaire unique, d'une impulsion en demi-dents de scie unique, d'une pluralité d'impulsions sinusoïdales, d'une pluralité d'impulsions rectangulaires, d'une pluralité d'impulsions en dents de scie, d'une pluralité d'impulsions demi-sinusoïdales, d'une pluralité d'impulsions demi-rectangulaires ou d'une pluralité d'impulsions en demi-dents de scie.

3. Dispositif (1) selon l'une des revendications précédentes,
le dispositif (1) étant configuré pour reconnaître une force exercée sur le dispositif (1).

4. Dispositif (1) selon l'une des revendications précédentes,
le dispositif (1) étant configuré pour reconnaître une tension générée entre les électrodes internes de l'actionneur piézoélectrique (4, 11), laquelle résulte d'une force exercée sur le dispositif (1) et
le dispositif (1) étant configuré pour reconnaître la force exercée sur le dispositif (1) à l'aide du niveau de la tension générée entre les électrodes internes.

5. Dispositif (1) selon l'une des revendications précédentes,
le dispositif (1) étant configuré pour générer la rétroaction haptique active en ce qu'une tension électrique, qui donne lieu à un changement de longueur de l'actionneur (4), est appliquée entre les électrodes internes de l'actionneur piézoélectrique (4, 11).

6. Dispositif (1) selon l'une des revendications précédentes,
le dispositif (1) étant configuré pour générer la rétroaction haptique qui simule le saut de force en modifiant brusquement la tension qui est appliquée à l'actionneur piézoélectrique (4, 11), ce qui provoque une vibration de l'actionneur piézoélectrique (4, 11).

7. Dispositif (1) selon la revendication précédente, une fréquence de vibration étant comprise dans une plage de 10 Hz à 500 Hz, de préférence dans une plage de 10 Hz à 100 Hz ou dans une plage de 250 Hz à 500 Hz.

8. Dispositif (1) selon l'une des revendications précédentes,
le premier élément de renforcement (5) possédant une tôle tronconique et le deuxième élément de renforcement (6) possédant une tôle tronconique.

9. Dispositif (1) selon la revendication précédente, les tôles tronconiques possèdent respectivement une zone de bord (5a, 6a) qui est fixée sur un côté supérieur (4a) ou un côté inférieur (4b) de l'actionneur piézoélectrique (4), et
les tôles tronconiques présentant respectivement une zone centrale (5b, 6b) qui fait saillie depuis le côté supérieur (4a) ou le côté inférieur (4b) et qui forme la zone partielle, laquelle est configurée pour être déplacée dans la deuxième direction (R2).

10. Dispositif (1) selon l'une des revendications 8 ou 9,
les tôles métalliques possédant respectivement du titane.

11. Dispositif (1) selon la revendication précédente, l'élément de renforcement (13a, 13b) mécanique étant un étrier métallique.

12. Dispositif (1) selon l'une des revendications précédentes,
l'élément de renforcement (13a, 13b) mécanique étant exempt d'encoches et présentant une épaisseur de paroi constante,
ou
l'élément de renforcement (13a, 13b) mécanique possédant au moins une encoche qui réduit une résistance mécanique à une déformation de l'élément de renforcement mécanique.

13. Dispositif (1) selon l'une des revendications précédentes,
l'actionneur piézoélectrique (4) possédant une surface de base carrée, ou
l'actionneur piézoélectrique (11) possédant une surface de base dont la longueur (L) est supérieure à sa largeur (B) .

14. Dispositif (1) selon l'une des revendications précédentes,
le dispositif (1) possédant une plaque de base (7) et une interface homme-machine (2), qui est configurée pour être actionnée par l'objet, et
l'actionneur piézoélectrique (4, 11) étant disposé entre la plaque de base (7) et l'interface homme-machine (2).

15. Procédé pour générer une rétroaction haptique active avec un dispositif (1) selon l'une des revendications précédentes,
une tension électrique appliquée à l'actionneur piézoélectrique (4, 11) étant modifiée par le circuit d'attaque (10) lorsqu'une force agissant sur le dispositif (1) dépasse un seuil de force.
